# DEMANDE DE BREVET EUROPEEN

(11) **EP 0 813 116 A1**
(43) Date de publication de la demande: **17.12.1997**
(21) Numéro de dépôt: 97470011.4
(22) Date de dépôt: 14.05.1997
(51) Int. Cl.: G03F 7/30

(54) **Procédé et dispositif pour la séparation totale en continu d'un mélange photopolymères et eau par membrane et filtres**

(30) Priorité: 14.06.1996 FR 9607583
(71) Demandeur: PHOTOMECA S.A. / EGG, 54340 Pompey (FR)
(72) Inventeur: Ferrante, Mario, 54520 Laxou (FR)
(74) Mandataire: Poupon, Michel

(57) **Abrégé**

La présente invention a pour objet un procédé pour la confection de clichés souples, utilisables pour la réalisation d'imprimés en flexographie, typographie ou offset sec, du type comportant:
- une étape de polymérisation de zones par exposition aux rayonnements ultraviolets,
- une étape de gravure des zones non polymérisées par immersion et brossage dans un bain de gravure contenu dans un bac de gravure, ledit bain se chargeant de particules dissoutes ou en suspension pendant l'étape de gravure,
- une séparation des composants du bain de gravure avec réinjection dans le bac de gravure du liquide obtenu lors de la séparation,
caractérisé en ce que la séparation consiste en une filtration avec concentration au fur et à mesure de la solution eau-polymères.

La présente invention concerne également un dispositif de gravure pour la confection de clichés souples utilisables pour la réalisation d'imprimés en flexographie, typographie ou offset sec du type comportant:
- une cuve de gravure contenant un bain (22) et des brosses (3),
- un dispositif de brassage et de chauffage,
- un système de trop-plein (20) pour évacuer la solution de la cuve de gravure par une canalisation de sortie (21) vers un dispositif de séparation, caractérisé en ce que le dispositif de séparation consiste essentiellement en un bac de réception (14) dont la partie haute est équipée d'un moyen de séparation (10) de l'eau et du polymère et d'au moins une membrane filtrante (7).

## Description

La présente invention concerne une machine perfectionnée de gravure pour la fabrication d'un cliché souple utilisable pour la réalisation d'imprimés en flexographie, typographie ou offset sec, elle concerne également un procédé pour la séparation des composants du bain de gravure contenu dans ladite machine.

On sait déjà que l'on peut obtenir un cliché pour la flexographie ou la typographie, en exposant une plaque de photopolymère sensible aux rayonnements ultraviolets, avec l'interposition d'un film négatif qui laisse exposées au rayonnement les zones qui doivent venir en relief sur le cliché terminé, ceci constitue l'étape d'insolation.

Le rayonnement durcit ces zones et on élimine ensuite la matière de la surface protégée en la brossant à l'aide de brosses planes ou rotatives ou par buses de pulvérisation ; de l'eau plus un détergent faisant office d'agent mouillant, on poursuit l'opération jusqu'à ce que les zones qui ont été exposées se trouvent suffisamment en relief, ceci constitue l'étape de gravure proprement dite.

Au cours de la gravure, l'eau plus le détergent se chargent puis se saturent en particules de polymère dissoutes et/ou en suspension, il faut donc procéder régulièrement à un changement du bain de gravure.

Un problème se pose concernant la solution aqueuse saturée qu'il faut traiter dans un dispositif de traitement indépendant de la machine de gravure. Le traitement de la solution ne permettant jamais d'éliminer totalement les particules de polymères, un problème se pose au niveau de la protection de l'environnement.

Le document FR 2 709 192 propose déjà une solution à ce problème sous la forme d'un dispositif et d'un procédé pour la confection de clichés photopolymères, utilisables pour la réalisation d'imprimés en flexographie, typographie ou offset sec, du type comportant une étape de polymérisation des zones par exposition aux rayonnements ultraviolets et une étape de gravure des zones par exposition aux rayonnements ultraviolets et une étape de gravure des zones non polymérisées par immersion et brossage dans un bac de gravure et qui comporte une séparation automatique et continue du bain de gravure avec réinjection automatique dans la cuve de gravure du liquide obtenu lors de la séparation.

Même si le procédé et le dispositif décrit dans le brevet cité ci-dessus donnent satisfaction, l'expérience montre que la bande de filtre qui reçoit et filtre la solution, et qui est évacuée dans un bac de stockage, contient encore une quantité importante de solution aqueuse sale. D'où un déplacement du problème d'environnement décrit précédemment.

Conformément à l'invention, le problème est résolu par un procédé pour la confection de clichés souples, utilisables pour la réalisation de clichés en flexographie, typographie ou offset sec, du type comportant :
- une étape de polymérisation de zones par exposition aux rayonnements ultraviolets et une étape de gravure des zones non polymérisées par immersion et brossage dans un bain de gravure contenu dans un bac de gravure,
- une étape de gravure des zones non polymérisées par immersion et brossage dans un hain de gravure contenu dans un bac de gravure, ledit bain se chargeant de particules dissoutes ou en suspension pendant l'étape de gravure,
- une séparation des composants du bain de gravure avec réinjection dans le bac de gravure du liquide obtenu lors de la séparation et qui comporte une séparation automatique et continue du bain de gravure avec réinjection automatique dans la cuve de gravure du liquide obtenu lors de la séparation, caractérisé en ce que ladite séparation consiste en une filtration avec concentration au fur et à mesure de la solution eau-polymères.

On obtient en appliquant le procédé suivant des particules de polymères sous forme solide qui sont plus faciles à traiter d'un point de vue écologique qu'un produit liquide ou semi-liquide comme c'était le cas précédemment, d'où un meilleur respect de l'environnement.

L'invention porte en outre sur tous les dispositifs de mise en oeuvre du procédé et notamment sur un mode de réalisation préféré mais non limitatif qui consiste en un dispositif de gravure pour la confection de clichés souples utilisables pour la réalisation d'imprimés en flexographie, typographie ou offset sec du type comportant :
- une cuve de gravure contenant un bain et des brosses,
- un dispositif de brassage et de chauffage,
- un système de trop-plein pour évacuer la solution de la cuve de gravure par une canalisation de sortie vers un dispositif de séparation, caractérisé en ce que le dispositif de séparation consiste essentiellement en un bac de réception dont la partie haute est équipée d'un moyen de séparation de l'eau et du polymère et d'au moins une membrane filtrante.

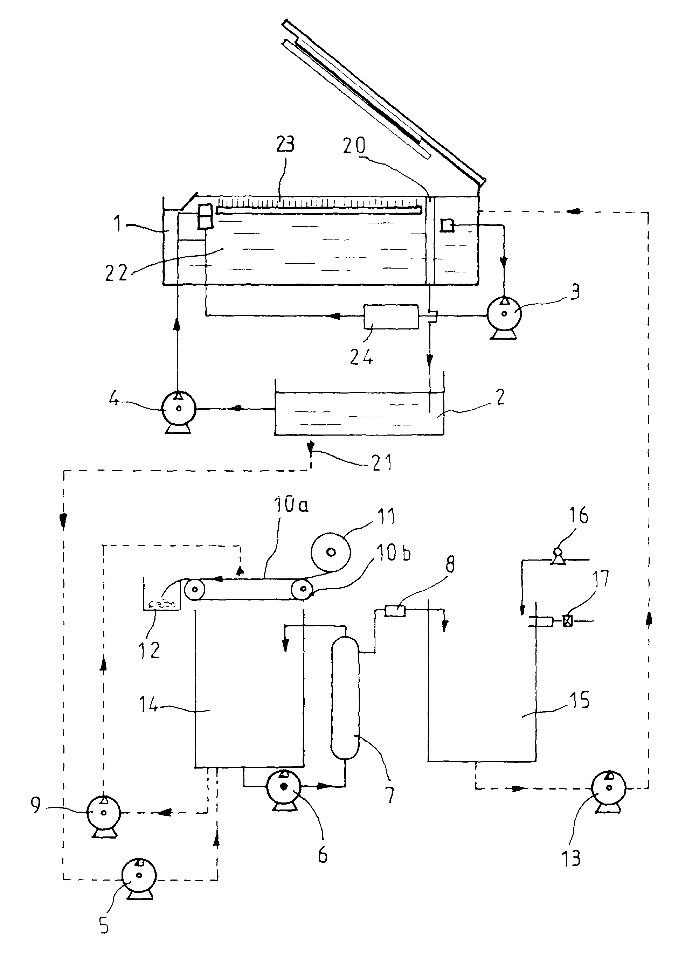

On comprendra mieux l'invention à l'aide de la description qui suit, en référence à la **figure unique** annexée.

La figure unique est un schéma de principe d'une machine à graver selon l'invention.

La machine à graver selon l'invention comporte en combinaison :
- une cuve de gravure (1) contenant un bain (22) et des brosses (23),
   Le bac de gravure (1) comporte un système de trop-plein (20) évacuant la solution par un canalisation de sortie (21) vers la cuve d'eau intermédiaire (2) puis par la pompe (5) vers un dispositif de séparation.
- une cuve intermédiaire (2) fonctionnant automatiquement en continu et en boucle fermée. Elle réceptionne l'eau sale arrivant du trop-plein (20) et l'évacue par la canalisation de sortie (21) vers le dispositif de séparation.

Ce dispositif de séparation est formé principalement d'un bac de réception (14) dont la partie haute est équipée d'un moyen de séparation (10) de l'eau et du polymère et d'au moins une membrane filtrante.

Selon un mode de réalisation préféré, le moyen de séparation est une bande de filtre (10a) provenant d'un rouleau d'alimentation (11) et pouvant être automatiquement déroulée par un système d'avance (10b) à rouleaux motorisés.

La bande de filtre (10a) reçoit et filtre la solution en provenance du bac (14) continuellement. Lorsque la bande (11) est saturée, le niveau de la solution monte et soulève un flotteur formant détecteur de saturation de filtre.

Le flotteur commande alors le système d'avance (10b) qui met en place une nouvelle bande de filtre, la bande saturée étant évacuée dans un bac de stockage (12).

Le produit filtré récupéré dans le bac de réception (14) est pompé par une pompe (9) et réinjecté en haut du bac de filtration.

On constate une légère baisse de niveau dans le bac de gravure en raison de l'évaporation. Cette évaporation est facilement compensée en ajoutant de l'eau dans la cuve intermédiaire (2), le volume du bac (2) faisant office de volume tampon.

On perfectionne encore la machine en y ajoutant un dispositif de brassage et de chauffage de la solution du bain consistant en une pompe de circulation (3) et un réchauffeur (24).

Le dispositif de brassage rend homogène la concentration de la solution du bain, diminue les dépôts de particules en fond de bac, évite l'encrassement des brosses.

La cuve d'eau sale (14) contient de l'eau et du polymère en constante circulation afin que le polymère ne se dépose pas,

Après le traitement de chaque plaque gravée, on prélève un volume d'eau sale de la cuve (2) avec la pompe (5) vers la cuve d'eau sale (14). Dans le même temps, on injecte le même volume d'eau propre par l'intermédiaire d'une pompe (13) dans la cuve de gravure (1).

La pompe haute-pression (6) aspire l'eau sale de la cuve (14) et l'insuffle dans une membrane filtrante (7).

Le nombre de membranes filtrantes (7) dépend des volumes d'eau à filtrer, donc du format des machines à graver.

Un faible débit d'eau propre est ainsi prélevé par "transpiration" au niveau de la membrane filtrante (7) et il est envoyé vers l'indicateur d'encrassement des membranes (8) pour le déverser dans la cuve (15) d'eau propre.

L'essentiel du débit de la pompe (6) revient plus concentré dans la cuve (14).

La solution eau + polymère se concentre donc progressivement dans la cuve (14) où une boue de photopolymère apparaît progressivement.

La pompe (9) d'alimentation du filtre (10) à déroulement du papier (11) aspire cette boue qui est filtrée en continu.

L'eau filtrée retombe dans le réservoir propre (15).

En effet, le réservoir propre (15) est situé en aval du dispositif pour récupérer l'eau filtrée par la ou les membranes filtrantes (7).

Un indicateur d'encrassement (8) est placé entre la ou les membranes filtrantes (7) et la cuve propre (15).

Le polymère reste sur un papier filtrant (11) puis ledit papier filtrant (11) est stocké dans le bac (12) pour être évacué comme déchet.

On peut adjoindre au système une alimentation automatique de détergent (16) contrôlée par un système d'analyse (17) pour reconditionner l'eau propre. L'eau propre ainsi reconditionnée sera renvoyée vers la cuve de gravure par l'intermédiaire d'une pompe d'eau propre (13).

Le procédé et le dispositif suivant l'invention présentent entre autres comme avantages :
- élimination des résidus liquides ou semi-liquides,
- rejet des résidus solides,
- utilisation rationalisée de l'eau qui permet de l'économiser au maximum,
- condition de gravure optimum,
- diminution du coût de la maintenance et de l'entretien.

## Revendications

1. Procédé pour la confection de clichés souples, utilisables pour la réalisation d'imprimés en flexographie, typographie ou offset sec, du type comportant :
- une étape de polymérisation de zones par exposition aux rayonnements ultraviolets,
- une étape de gravure des zones non polymérisées par immersion et brossage dans un bain de gravure contenu dans un bac de gravure, ledit bain se chargeant de particules dissoutes ou en suspension pendant l'étape de gravure,
- une séparation des composants du bain de gravure avec réinjection dans le bac de gravure du liquide obtenu lors de la séparation,
caractérisé en ce que la séparation consiste en une filtration avec concentration au fur et à mesure de la solution eau-polymères.

2. Dispositif de gravure pour la confection de clichés souples utilisables pour la réalisation d'imprimés en flexographie, typographie ou offset sec du type comportant :
- une cuve de gravure contenant un bain (22) et des brosses (3),
- un dispositif de brassage et de chauffage,
- un système de trop-plein (20) pour évacuer la solution de la cuve de gravure par une canalisation de sortie (21) vers un dispositif de séparation, caractérisé en ce que le dispositif de séparation consiste essentiellement en un bac de réception (14) dont la partie haute est équipée d'un moyen de séparation (10) de l'eau et du polymère et d'au moins une membrane filtrante (7).

3. Dispositif de gravure selon la revendication 2, caractérisé en ce que le moyen de séparation est formé d'une bande de filtre (10a) provenant d'un rouleau d'alimentation (11) et pouvant être déroulée automatiquement par un système d'avancée (10b) à rouleaux motorisés de façon à remplacer la partie saturée de la bande sur commande d'un détecteur de saturation de filtre.

4. Dispositif de gravure selon la revendication 2, caractérisé en ce qu'un réservoir propre (15) est situé en aval du dispositif pour récupérer l'eau filtrée par le ou les membranes filtrantes (7).

5. Dispositif de gravure selon la revendication 4, caractérisé en ce qu'un indicateur d'encrassement de membrane (8) est placé entre le ou les membranes filtrantes (7) et la cuve propre (15).

6. Dispositif de gravure selon l'une quelconque des revendications 4 ou 5, caractérisé en ce qu'une alimentation en détergent (16) est adjointe à la cuve propre (15).

7. Dispositif de gravure selon la revendication 6, caractérisé en ce qu'un système d'analyse (17) contrôle l'alimentation automatique en détergent (16).

8. Dispositif de gravure selon la revendication 1, caractérisé en ce qu'il comporte une cuve intermédiaire (2) fonctionnant automatiquement en continu et en boucle ; ladite cuve intermédiaire (2) réceptionnant l'eau sale arrivant du trop-plein (20) et l'évacuant par la canalisation de sortie (21) vers le dispositif de séparation.

9. Dispositif de gravure selon la revendication 2, caractérisé en ce que le dispositif de brassage et de chauffage consiste en une pompe de circulation (3) et un réchauffeur (24).
